# EUROPEAN PATENT SPECIFICATION

(11) **EP 2 092 034 B1**
(45) Date of publication and mention of the grant of the patent: **29.02.2012**
(21) Application number: 06823817.9
(22) Date of filing: 29.11.2006
(51) Int. Cl.: C09K 3/14, H01L 21/321, C09G 1/02

(54) **CHEMICAL MECHANICAL POLISHING SLURRY COMPOSITIONS, METHODS OF PREPARING THE SAME AND METHODS OF USING THE SAME**
CMP-MASSEN, HERSTELLUNGSVERFAHREN DAFÜR UND IHRE VERWENDUNG
COMPOSITIONS DE BOUES DE POLISSAGE MÉCANO-CHIMIQUE, PROCÉDÉS DE PRÉPARATION DE CES COMPOSITIONS ET PROCÉDÉS D'UTILISATION DE CES COMPOSITIONS

(30) Priority: 07.11.2006 KR 20060109195
(43) Date of publication of application: 26.08.2009
(73) Proprietor: Cheil Industries INC., Gumi-si 730-710 (KR)
(72) Inventor: CHOUNG, Jae Hoon, Gyeonggi-do 435-050 (KR); LEE, In Kyung, Gyeounggi-do 437-080 (KR)
(74) Representative: Bublak, Wolfgang
(86) International application number: PCT/KR2006/005109
(87) International publication number: WO 2008/056847

(56) References cited:
- WO-A1-02/31072
- JP-A- 2006 066 874
- KR-B1- 100 643 628
- US-A- 5 502 251
- US-A1- 2002 064 955
- US-A1- 2005 050 803

## Description

### Technical Field

The present invention relates to chemical mechanical polishing (CMP) slurry compositions, and more particularly to CMP slurry compositions for polishing polycrystalline silicon surfaces. The present invention also relates to methods of preparing CMP slurry compositions and methods of polishing polycrystalline silicon surfaces.

### Background Art

Ultra large scale integration (ULSI) of integrated circuit technology, which may be represented by 512M-bit and 1G-bit Dynamic Random Access Memories (DRAMs), may be achieved through high performance and high integration of semiconductor devices. Thus, as the minimum processing size required for the fabrication of devices becomes smaller, relatively small line widths (*e.g.,* 55 to 60 nm) may be formed in the fabrication of next-generation devices.

Integration in integrated circuits has resulted in the reduction of the size of semiconductor devices and a need for multilevel interconnection. Highly integrated semiconductor devices may be fabricated by repeatedly and alternately depositing conductive and insulating materials over one another to form patterns. When the surface of each material layer is not planarized upon pattern formation, it may be difficult to form new pattern layers over the top. For example, in the case where new layers are continuously laminated on non-uniform surfaces between material layers, incident light may be reflected at different angles from refracted films, resulting in inaccurate photo resist patterns upon development. Thus, it may be necessary to planarize the surface of semiconductor materials in order to achieve effective lithography. Toward this end, chemical mechanical polishing (CMP) may be a desirable planarization technique. CMP of polycrystalline silicon may be particularly important because polycrystalline silicon materials are widely used to form contacts and lines in devices in semiconductor manufacturing processes.

CMP compositions generally include a slurry, which is typically an abrasive solution. In some processes, the slurry may be supplied to the space between the wafer and the surface of a polishing pad, so that the slurry may chemically react with the surface of the wafer while the polishing pad physically removes portions of the surface of the wafer.

Slurries used in semiconductor CMP processes may include, for example, deionized water, a metal oxide, a base or acid for pH adjustment, an additive for controlling the polishing rate and selectivity, and the like. Metal oxides may include silica, alumina, ceria, zirconia, titania, and the like, which are often produced by a fuming or sol-gel process. Amine-based additives may be helpful in achieving relatively high polishing rates towards polycrystalline silicon films, while at the same time, providing low polishing rates towards insulating layers.

Various methods of altering polishing slurries in order to increase the polishing rate in CMP processes have been attempted. For example, U.S. Patent No. 4,169,337 discusses the addition of an echant, such as aminoethylethanolamine. U.S. Patent Nos. 3,262,766 and 3,768,989 discuss the preparation of polishing compositions by coprecipitating small amounts of other particles, such as CeO₂ particles during production of SiO₂. Further, the addition of inorganic salts, such as Ce(OH)₄, NH₄SO₄ and Fe(SO₄ ), to a slurry is discussed in Mechanism of Glass Polishing Vol. 152, 1729, 1971. In addition, U.S. Patent No. 4,169,337 discusses a slurry composed of silica/ amine/organic salt/polyhydric alcohol; U.S. Patent No. 4,169,337 discusses a slurry composed of silica/amine; U.S. Patent No. 5,139,571 discusses a slurry composed of silica/quaternary ammonium salt; U.S. Patent No. 5,759,917 discusses a slurry composed ceria/carboxylic acid/silica; U.S. Patent No. 5,938,505 discusses a slurry composed of tetramethyl ammonium salt/hydrogen peroxide; and WO 0231072 discusses a slurry comprising fumed silica, tetramethyl ammonium hydroxide and a fluorinated surfactant.

Slurries used for polishing polycrystalline silicon films may have a polishing selectivity for polycrystalline silicon films relative to insulating oxide films that are used as stop layers. However, this polishing selectivity may result in dishing of the polycrystalline silicon films due to the chemical mechanical action. The occurrence of dishing may adversely affect subsequent photo processing, which may result in height differences upon the formation of polycrystalline silicon lines. As a result, the electrical properties and contact characteristics inside cells may be deteriorated. Thus, there is a need for slurry compositions that ameliorate or eliminate the problem of dishing and thus improve the within-wafer-non-uniformity.

### Disclosure of Invention

### Technical Problem

Therefore, the present invention has been made in view of the above problems of the prior art, and it is an object of the present invention to provide chemical mechanical polishing (CMP) slurry compositions with high selectivity that include a metal oxide and additives, including a fluorinated surfactant and a quaternary ammonium surfactant.

### Technical Solution

Provided in some embodiments of the present invention are chemical mechanical polishing (CMP) slurry compositions, including:
(a) a metal oxide;
(b) a pH-adjusting agent;
(c) a fluorinated surfactant; and
(d) a quaternary ammonium surfactant represented by Formula 2: 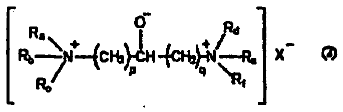 wherein Rₐ, R_{b}, R_{c}, R_{d}, Rₑ and R_{f} may each independently be a C₁₋₂₀ alkyl group; X⁻ may be a halogen anion; and p and q may each independently be an integer in a range of 1 and 10.

In some embodiments of the invention, the fluorinated surfactant may include a non-ionic perfluoroalkyl sulfonyl compound In some embodiments, the non-ionic perfluoroalkyl sulfonyl compound may include a compound represented by Formula 1:

CP₃(CF₂)ₙSO₂X (1)

wherein n may be an integer from 1 to about 20;
X may be COOR, OR, (OCH₂CH₂)ₘOCH₂CH₃ or (OCH₂CH(OH)CH₂)ₘOCH₂ CH(OH)CH₃;
R may be a C₁₋₂₀ alkyl group;
and m may be an integer from 1 to about 100.

In some embodiments, the fluorinated surfactant is present in the slurry composition in amount in a range of about 0.001% to about 1% by weight, based on the total weight of the slurry composition.

In some embodiments, the quaternary ammonium surfactant is present in the slurry composition in amount in a range of about 0.001 % to about 1 % by weight, based on the total weight of the slurry composition.

In some embodiments of the invention, the pH-adjusting agent may include a quaternary ammonium base. In some embodiments, the pH-adjusting agent is present in an amount in a range of about 0.01% to about 5% by weight, based on the total weight of the slurry composition.

In some embodiments of the invention, the metal oxide includes at least one of SiO , Al₂O₃, CeO₂, ZrO₂ and TiO₂. In particular embodiments, the metal oxide may have a primary particle size in a range of about 10 nm to about 300 nm and a specific surface area in a range of about 10 to about 300 m²/g.

Also provided are methods of preparing slurry compositions according to embodiments of the invention.

In addition, provided herein are methods of polishing a polycrystalline silicon surface, including supplying a slurry composition according to an embodiment of the invention to a polycrystalline silicon surface and performing a CMP process to polish the polycrystalline silicon surface.

### Best Mode for Carrying Out the Invention

The invention is described more fully hereinafter. This invention may, however, be embodied in many different forms and should not be construed as limited to the embodiments set forth herein. Rather, these embodiments are provided so that this disclosure will be thorough and complete, and will fully convey the scope of the invention to those skilled in the art.

The terminology used herein is for the purpose of describing particular embodiments only and is not intended to be limiting of the invention. As used herein, the singular forms "a", "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All references cited in the present specification are herein incorporated by reference.

In some embodiments of the present invention, chemical mechanical polishing (CMP) slurry compositions may include.
(a) a metal oxide;
(b) a pH-adjusting agent;
(c) a fluorinated surfactant; and 2
(d) a quaternary ammonium surfactant represented by Formula 2.

Any suitable metal oxide may be used provided that it can be produced by a fuming or sol-gel process. Suitable metal oxides include, but are not limited to, silica (SiO₂), alumina (Al₂O₃), ceria (CeO₂), zirconia (ZrO₂), and titania (TiO₂), and the like. The metal oxides may be used alone or in combination.

In some embodiments of the invention, the metal oxide has a primary particle size in a range of about 10 nm to about 300 nm, and in some embodiments in a range of about 20 nm to about 300 nm, as determined by transmission electron microscopy (TBM). In some embodiments, the metal oxide has a specific surface area in a range of about 10 to about 300 m²/g. In a particular embodiment, the metal oxide includes silica particles. When the primary particle size is below about 10 nm, the polishing rate (i.e., removal rate) may be relatively low, which may undesirably decrease throughout. However, when the primary particle size is above about 300 nm, a significant quantity of large particles may be present, which may lead to the formation of µ-scratches. In some embodiments of the present invention, the metal oxide is present in the slurry in an amount in a range of about 0.1 to about 30% by weight, and in some embodiments, in a range of about 1 to about 20% by weight, based on the total weight of the composition.

CMP slurry compositions according to embodiments of the present invention may have a pH of at least about 9, which may provide for a desirable polycrystalline silicon polishing rate. Toward this end, CMP slurry compositions according to embodiments of the present invention may include a pH-adjusting agent which may include a quaternary ammonium base. Suitable quaternary ammonium bases include, but are not limited to, tetramethyl ammonium hydroxide, tetraethyl ammonium hydroxide, tetrapropyl ammonium hydroxide and tetrabutyl ammonium hydroxide. The pH-adjusting agents may be used alone or in any combination. In some embodiments, the pH-adjusting agent may be present in the CMP slurry composition in an mount in a range of about 0.01 to about 5% by weight, based on the total weight of the slurry. However, in some embodiments, the pH-adjusting agent may be present in the CMP slurry composition in an amount in a range of about 0.01 to about 1% by weight.

The fluorinated surfactant may be useful to control the polishing rate and may improve the within-wafer-non-uniformity of a polycrystalline silicon film.

In some embodiments, the fluorinated surfactant may include a non-ionic perfluoroalkyl sulfonyl compound. The perfluoroalkyl moiety of the non-ionic perfluoroalkyl sulfonyl compound may include a linear, branched or cyclic perfluoroalkyl. Furthermore, the non-ionic perfluoroalkyl sulfonyl compound may include a non-fluorinated alkyl spacer, such as a methylene or ethylene group, between the sulfonyl group and the perfluoroalkyl group. In some embodiments, the non-ionic perfluoroalkyl sulfonyl compound includes a compound represented by Formula 1:

CF₃(CF₂)ₙSO₂X (1)

wherein n may be an integer from 1 to about 20; X may be COOR, OR, (OCH₂CH₂) ₘOCH₂CH₃ or (OCH₂CH(OH)CH₂)ₘOCH₂CH(OH)CH₃; R may be a C₁₋₂₀ alkyl group; and m may be an integer from 1 to about 100. The term C₁₋₂₀ alkyl, as used herein, refers to an alkyl group having 1 to 20 carbon atoms. In addition, in some embodiments, n may be an integer in a range of 1 and about 8.

In some embodiments of the present invention, at least two different fluorinated surfactants represented by Formula 1 may be simultaneously used in the present invention.

In some embodiments, the fluorinated surfactant may be present in the CMP slurry composition in a range of about 0.001 to about 1% by weight, based on the total weight of the slurry. In particular embodiments, the fluorinated surfactant is present in the CMP slurry composition in an amount in a range of about 0.001 to about 0.5% by weight. When the fluorinated surfactant is present in an amount of less than about 0.001% by weight, the polishing rate of polycrystalline silicon may be too high and edge portions of a wafer may be excessively polished, which may deteriorate the within-wafer-non-uniformity. However, when the fluorinated surfactant is present in an amount exceeding about 1% by weight, the polishing rate of polycrystalline silicon may be too low and edge portions of a wafer may not be adequately polished, which may deteriorate the within-wafer-non-uniformity. In addition, by appropriately controlling the content of fluorinated surfactant in the CMP slurry composition, the edge profile may be improved and dishing may be decreased.

The quaternary ammonium surfactant represented by Formula 2 may be useful to improve the polishing selectivity for polycrystalline silicon films relative to insulating oxide films and may improve the within-wafer-non-uniformity of a polycrystalline silicon film.

The quaternary ammonium surfactant is represented by Formula 2: 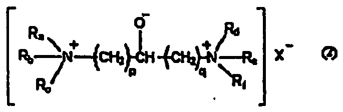 wherein Rₐ, R_{b}, R_{c}, R_{d}, Rₑ and R may each independently be a C₁₋₂₀ alkyl group; X⁻ may be a halogen anion; and p and q may each independently be an integer in a range of 1 and 10. In addition, in some embodiments, Rₐ, R_{b}, R_{c}, R_{d}, Rₑ and R_{f} may each independently be an alkyl group having from 1 to about 4 carbon atoms. Furthermore, in some embodiments, p and q may each independently be an integer in a range of 1 to 3, and in particular embodiments, p and q may each be 1. In some embodiments, X⁻ may be Cl⁻.

In some embodiments of the present invention, at least two different quaternary ammonium salts represented by Formula 2 may be simultaneously used in a composition according to the present invention.

In some embodiments, the quaternary ammonium surfactant represented by Formula 2 may be present in the CMP slurry composition in a range of about 0.001 to about 1% by weight, based on the total weight of the slurry. In particular embodiments, the quaternary ammonium surfactant is present in the CMP slurry composition in an amount in a range of about 0.001 to about 0.5% by weight When the quaternary ammonium surfactant is present in an amount of less than about 0.001 % by weight, the polishing rate of polycrystalline silicon may be too low and the polycrystalline silicon residue, which should be removed after polishing, may be detected on the surface of formed patterns. However, when the quaternary ammonium surfactant is present in an amount exceeding about 1% by weight, the polishing rate of polycrystalline silicon may be too high and dishing may occur, which may deteriorate the within-wafer-non-uniformity.

In some embodiments of the invention, the selectivity of a CMP slurry composition according to an embodiment of the present invention towards a polycrystalline silicon film relative to an insulating oxide film may be in a range of about 50:1 to about 1000:1.

Also provided in some embodiments of the invention are methods for preparing a CMP slurry composition according to an embodiment of the invention including adding about 0.001 to about 1% by weight of a fluorinated surfactant about 0.001 to about 1% by weight of a quaternary ammonium surfactant represented by Formula 2, about 0.01 to about 5% by weight of a pH-adjusting agent and about 0.1 to about 30% by weight of the metal oxide to water which is present in a range of about 65 to 99% by weight, based on the total weight of the slurry, followed by agitation of the mixture. In some embodiments, the fluorinated surfactant includes a non-ionic perfluoroalkyl sulfonyl compound, and in some embodiments, the fluorinated surfactant includes a compound represented by Formula 1. In some embodiments, the pH-adjusting agent includes a quaternary ammonium base. In some embodiments, the water is ultrapure water.

In some embodiments of the present invention, methods of polishing a polycrystalline silicon surface include supplying a slurry composition according to an embodiment of the invention to a polycrystalline silicon surface and performing a CMP process to polish the polycrystalline silicon surface.

### Mode for the Invention

The present invention will now be described in more detail with reference to the following examples. However, these examples are given for the purpose of illustration and are not to be construed as limiting the scope of the invention.

### EXAMPLES

### Example 1

First, 12.5g of an aqueous solution of 20 wt% tetramethylammonium hydroxide (TMAH) was added to 4111.9g of ultrapure water. Ten minutes after the addition, 0.1g of polyoxyethylene perfluorobutyl sulfonyl ester and 0.5g of the compound of Formula 3 were added thereto.

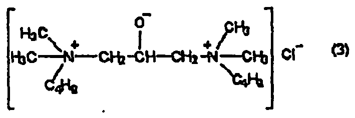

This mixture was combined with 875g of an aqueous solution of 20 wt% colloidal silica in a reactor. The resulting mixture was stirred at 500 rpm and filtered through a 5 micron filter to obtain a slurry. Wafers were polished using the slurry for one minute under the following conditions: polishing machine: MIRRA (AMAT); polishing pad: IC1010/Suba IV K groove (Rhom & Haas); polishing substrate: Poly-Si, PTEOS, 8" blanket wafer; plate speed: 120 rpm; head speed: 115 rpm; pressure: 2.0 psi; temperature: 25°C; and slurry flow: 200 ml/min. The thickness of the wafer before and after the polishing was measured, and the within-wafer-non-uniformity (WIWNU) was evaluated at portions other than within 3 mm of the edge by 98-point analysis using an optiprobe. The results are shown in Table 1 below.

### Example 2

A slurry was obtained in the same manner as in Example 1, except that 1.0g of the compound of Formula 3 was added. The polishing performance of the slurry was evaluated in accordance with the procedure described in Example 1. The results are shown in Table 1 below.

### Example 3

A slurry was obtained in the same manner as in Example 1, except that 1.5g of the compound of Formula 3 was added. The polishing performance of the slurry was evaluated in accordance with the procedure described in Example 1. The results are shown in Table 1 below.

**Table 1**

| | Colloidal silica (20%) | Amount | | | Polishing performance | | | | |
|---|---|---|---|---|---|---|---|---|---|
| | | Polyoxyethylene perfluorobutyl sulfonyl ester | TMAH (20%) | Cmpd of Formula 3 | Poly-Si | | PTEOS | | Selectivity |
| | | | | | Polishing rate (Å/min.) | WIWNU (%) | Polishing rate (ÅminJ | WIWNU (%) | |
| Ex.1 | 875g | 0.1g | 12.5g | 0.5g | 1851 | 2.41 | 16 | 2.75 | 118 |
| Ex.2 | 875g | 0.1g | 12.5g | 1.0g | 2289 | 2.91 | 10 | 2.58 | 227 |
| Ex.3 | 875g | 0.1g | 12.5g | 1.5g | 2508 | 3.15 | 5 | 2.61 | 502 |

As can be seen from the data shown in Tables 1, as the concentration of the quaternary ammonium surfactant was increased, the polishing selectivity for polycrystalline silicon films relative to insulating oxide films was improved.

### Comparative Example 1.

A slurry was obtained in the same manner as in Example 1, except that the compound of Formula 3 was omitted. The polishing performance of the slurry was evaluated in accordance with the procedure described in Example 1. The results are shown in Table 2 below.

### Comparative Example 2

A slurry was obtained in the same manner as in Example 1, except that polyoxyethylene perfluorobutyl sulfonyl ester was omitted. The polishing performance of the slurry was evaluated in accordance with the procedure described in Example 1. The results are shown in Table 2 below.

**Table 2**

| | Colloidal silica (20%) | Amount | | | Polishing performance | | | | |
|---|---|---|---|---|---|---|---|---|---|
| | | Polyoxyethylene perfluorobutyl sulfonyl ester | TMAH (20%) | Cmpd of Formula 3 | Poly-Si | | PTEOS | | Selectivity |
| | | | | | Polishing rate (Å/min.) | WIWNU (%) | Polishing rate (Å/min.) | WIWNU (%) | |
| Comp Ex.1 | 875g | 0.1 g | 12.5g | - | 1251 | 6.84 | 38 | 3.35 | 33 |
| Comp .Ex.2 | 875g | - | 12.5g | 0.5g | 2481 | 7.95 | 14 | 3.54 | 177 |

As can be seen from the data shown in Tables 2, the polishing selectivity for polycrystalline silicon films relative to insulating oxide films was significantly decreased when the quaternary ammonium surfactant was omitted. In addition, when the quaternary ammonium surfactant or the fluorinated surfactant was omitted, the within-wafer-non-uniformity was deteriorated.

### Comparative Example 3

A slurry was obtained in the same manner as in Example 1, except that ethylene diamine was added instead of the compound of Formula 3. The polishing performance of the slurry was evaluated in accordance with the procedure described in Example 1. The results are shown in Table 3 below

**Table 3**

| | Colloidal silica (20%) | Amount | | | Polishing performance | | | | |
|---|---|---|---|---|---|---|---|---|---|
| | | Polyoxyethylene perfluorobutyl sulfonyl ester | TMAH (20%) | ethylene diamine | Poly-Si | | PTEOS | | Selectivity |
| | | | | | Polishing rate (Å/min.) | WIWNU (%) | Polishing rate (Å/min.) | WIWNU (%) | |
| Comp .Ex.3 | 875g | 0.1g | 12.5g | 0.5g | 1540 | 6.98 | 51 | 3.15 | 30 |

As can be seen from the data shown in Tables 3, the polishing selectivity for polycrystalline silicon films relative to insulating oxide films was significantly decreased and the within-wafer-non-uniformity was deteriorated when ethylene diamine was added instead of the quaternary ammonium surfactant.

As apparent from the above description, the present invention provides CMP slurry compositions for polishing polycrystalline silicon films that may improve or eliminate the problem of dishing, thus providing desirable within-wafer-non-uniformity, while maintaining sufficient selectivity.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A chemical mechanical polishing (CMP) slurry composition, comprising:
(a) a metal oxide;
(b) a pH-adjusting agent;
(c) a fluorinated surfactant; and
(d) a quaternary ammonium surfactant represented by Formula 2: 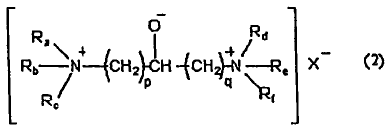 wherein Rₐ, R_{b}, R_{c}, R_{d}, R_{c} and R_{f} are each independently a C₁₋₂₀ alkyl group; X is a halogen anion; and p and q are each independently an integer in a range of 1 and 10.

2. The CMP slurry composition of claim 1, wherein the fluorinated surfactant comprises a non-ionic perfluoroalkyl sulfonyl compound.

3. The CMP slurry composition of claim 2, wherein the non-ionic perfluoroalkyl sulfonyl compound comprises a compound represented by Formula 1:
CF₃(CF₂)ₙSO₂X (1)
wherein n is an integer from 1 to about 20;
X is selected from the group consisting of COOR, OR, (OCH₂CH₂)ₘOCH₂CH₃ and (OCH₂CH(OH)CH₂)ₘOCH₂CH(OH)CH₃;
R is a C₁₋₂₀ alkyl group;
and m is an integer from 1 to about 100.

4. The slurry composition according to claim 1, wherein the fluorinated surfactant is present in an amount in a range of about 0.001% to about 1% by weight, based on the total weight of the slurry composition.

5. The CMP slurry composition of claim 1, wherein Rₐ, R_{b}, R_{c}, R_{d}, Rₑ and R_{f} are each independently a C₁-C₄ alkyl group; p and q are each 1; and X⁻ is Cl⁻.

6. The slurry composition according to claim 1, wherein the quaternary ammonium surfactant is present in an amount in a range of about 0.001% to about 1% by weight, based on the total weight of the slurry composition.

7. The CMP slurry composition of claim 1, wherein the pH-adjusting agent comprises a quaternary ammonium base.

8. The slurry composition according to claim 7, wherein the quaternary ammonium base comprises at least one compound selected from the group consisting of tetramethyl ammonium hydroxide, tetraethyl ammonium hydroxide, tetrapropyl ammonium hydroxide and tetrabutyl ammonium hydroxide.

9. The slurry composition according to claim 1, wherein the pH-adjusting agent is present in an amount in a range of about 0.01% to about 5% by weight, based on the total weight of the slurry composition.

10. The slurry composition according to claim 1, wherein the metal oxide comprises at least one compound selected from the group consisting of SiO₂, Al₂O₃, CeO₂, ZrO₂ and TiO₂.

11. The slurry composition according to claim 1, wherein the metal oxide has a primary particle size in a range of about 10 nm to about 300 nm and a specific surface area in a range of about 10 to about 300 m²/g.

12. The slurry composition according to claim 3, wherein the fluorinated surfactant comprises at least two different fluorinated surfactants, wherein the at least two different fluorinated surfactants are represented by Formula 1.

13. The slurry composition according to claim 1, wherein the quaternary ammonium surfactant comprises at least two different quaternary ammonium surfactants represented by Formula 2.

14. A method for preparing a CMP slurry composition comprising adding about 0.001 to about 1% by weight of a fluorinated surfactant, about, 0.001 to about 1% by weight of a quaternary ammonium surfactant represented by Formula 2: 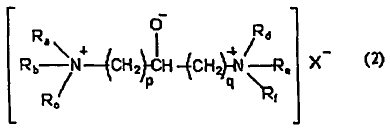 wherein Rₐ, R_{d}, R_{c}, R_{d}, Rₑ and R_{f} are each independently a C₁₋₂₀ alkyl group; X⁻ is a halogen anion; and p and q are each independently an integer in a range of 1 and 10, about 0.01 to about 5% by weight of a pH-adjusting agent and about 0.1 to 30% by weight of a metal oxide into water, which is present in an amount in a range of about 65 to 99% by weight, based on the total weight of the slurry, to form a mixture, and agitating the mixture.

15. The method of claim 14, wherein the fluorinated surfactant is a non-ionic perfluoroalkyl sulfonyl compound represented by Formula 1:
CF₃(CF₂)ₙSO₂X (1)
wherein n is an integer from 1 to about 20;
X is selected from the group consisting of COOR, OR, (OCH₂CH₂)ₘOCH₂CH₃ and (OCH₂CH(OH)CH₂)ₘOCH₂CH(OH)CH₃;
R is a C₁₋₂₀ alkyl group; and
m is an integer from 1 to about 100.

16. The method of claim 15, wherein Rₐ, R_{b}, R_{c}, R_{d}, Rₑ and R_{f} are each independently a C₁-C₄ alkyl group; p and q are each 1; and X⁻ is Cl⁻.

17. A method for polishing a polycrystalline silicon surface, comprising supplying a slurry composition to a polycrystalline silicon surface, wherein the slurry composition comprises (a) a metal oxide; (b) a pH-adjusting agent ; (c) a fluorinated surfactant; and (d) a quaternary ammonium surfactant represented by Formula 2: 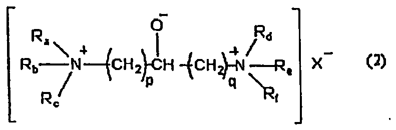 wherein Rₐ, R_{b}, R_{c}, R_{d}, Rₑ and R_{f} are each independently a C₁₋₂₀ alkyl group; X⁻ is a halogen anion; and p and q are each independently an integer in a range of 1 and 10; and performing a CMP process to polish the polycrystalline silicon surface.

18. The method of claim 17, wherein the fluorinated surfactant is a non-ionic perfluoroalkyl sulfonyl compound represented by Formula 1.
CF₃(CF₂)ₙSO₂X (1)
wherein n is an integer from 1 to about 20;
X is selected from the group consisting of COOR, OR, (OCH₂CH₂)ₘOCH₂CH₃ and (OCH₂CH(OH)CH₂)ₘOCH₂CH(OH)CH₃;
R is a C₁₋₂₀ alkyl group; and
m is an integer from 1 to about 100.

19. The method of claim 17, wherein Rₐ, R_{b}, R_{c}, R_{d}, Rₑ and R_{f} are each independently a C₁-C₄alkyl group; p and q are each 1; and X⁻ is Cl⁻.

## Patentansprüche

1. Chemisch-mechanische polierende (CMP-) Schlämmzusammensetzung, umfassend:
(a) ein Metalloxid;
(b) ein pH-einstellendes Mittel;
(c) ein fluoriertes oberflächenaktives Mittel; und
(d) eine quartäre oberflächenaktive Ammoniumverbindung der Formel 2 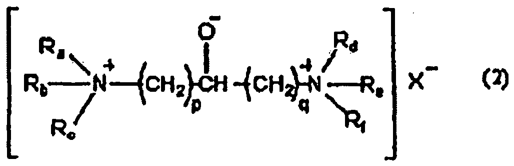 wobei Rₐ, R_{b}, R_{c}, R_{d}, Rₑ und R_{f} jeweils unabhängig eine C₁₋₂₀-Alkylgruppe sind; X⁻ ein Halogenanion ist; und p und q jeweils unabhängig eine ganze Zahl in einem Bereich von 1 und 10 sind.

2. CMP-Schlämmzusammensetzung nach Anspruch 1, wobei das fluorierte oberflächenaktive Mittel eine nicht-ionische Perfluoralkylsulfonylverbindung umfasst.

3. CMP-Schlämmzusammensetzung nach Anspruch 2, wobei die nichtionische Perfluoralkylsulfonylverbindung eine Verbindung der Formel 1 umfasst:
CF₃(CF₂)ₙSO₂X (1)
wobei n eine ganze Zahl von 1 bis etwa 20 ist; X ausgewählt ist aus der Gruppe, bestehend aus COOR, OR, (OCH₂CH₂)ₘOCH₂CH₃ und (OCH₂CH(OH)CH₂)ₘOCH₂CH(OH)CH₃; R eine C₁₋₂₀-Alkylgruppe ist; und m eine ganze Zahl von 1 bis etwa 100 ist.

4. Schlämmzusammensetzung nach Anspruch 1, wobei das fluorierte oberflächenaktive Mittel in einer Menge in einem Bereich von etwa 0,001 bis etwa 1 Gew.-%, basierend auf dem Gesamtgewicht der Schlämmzusammensetzung, vorliegt.

5. Schlämmzusammensetzung nach Anspruch 1, wobei Rₐ, R_{b}, R_{c}, R_{d}, Rₑ und R_{f} jeweils unabhängig eine C₁-C₄-Alkylgruppe sind; p und q jeweils 1 sind; und X⁻ Cl⁻ ist.

6. Schlämmzusammensetzung nach Anspruch 1, wobei die quartäre oberflächenaktive Ammoniumverbindung in einer Menge in einem Bereich von etwa 0,001 bis etwa 1 Gew.-%, basierend auf dem Gesamtgewicht der Schlämmzusammensetzung, vorliegt.

7. CMP-Schlämmzusammensetzung nach Anspruch 1, wobei das pH-einstellende Mittel eine quartäre Ammoniumbase umfasst.

8. Schlämmzusammensetzung nach Anspruch 7, wobei die quartäre Ammoniumbase mindestens eine Verbindung, ausgewählt aus der Gruppe, bestehend aus Tetramethylammoniumhydroxid, Tetraethylammoniumhydroxid, Tetrapropylammoniumhydroxid und Tetrabutylammoniumhydroxid, umfasst.

9. Schlämmzusammensetzung nach Anspruch 1, wobei das pH-einstellende Mittel in einer Menge in einem Bereich von etwa 0,01 bis etwa 5 Gew.-%, basierend auf dem Gesamtgewicht der Schlämmzusammensetzung, vorliegt.

10. Schlämmzusammensetzung nach Anspruch 1, wobei das Metalloxid mindestens eine Verbindung, ausgewählt aus der Gruppe, bestehend aus SiO₂, Al₂O₃, CeO₂, ZrO₂ und TiO₂, umfasst.

11. Schlämmzusammensetzung nach Anspruch 1, wobei das Metalloxid eine primäre Teilchengröße in einem Bereich von etwa 10 nm bis etwa 300 nm und einen spezifischen Oberflächenbereich in einem Bereich von 10 bis etwa 300 m²/g aufweist.

12. Schlämmzusammensetzung nach Anspruch 3, wobei das fluorierte oberflächenaktive Mittel mindestens zwei verschiedene fluorierte oberflächenaktive Mittel umfasst, wobei die mindestens zwei verschiedenen fluorierten oberflächenaktiven Mittel durch die Formel 1 dargestellt sind.

13. Schlämmzusammensetzung nach Anspruch 1, wobei die quartäre oberflächenaktive Ammoniumverbindung mindestens zwei verschiedene quartäre oberflächenaktive Ammoniumverbindungen der Formel 2 umfasst.

14. Verfahren zur Herstellung einer CMP-Schlämmzusammensetzung, umfassend Zugabe von etwa 0,001 bis etwa 1 Gew.-% eines fluorierten Oberflächenaktiven Mittels, etwa 0,001 bis etwa 1 Gew.-% einer quartären oberflächenaktiven Ammoniumverbindung der Formel 2 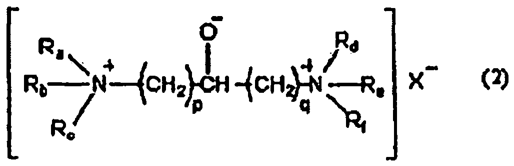 wobei Rₐ, R_{b}, R_{c}, R_{d}, Rₑ und R_{f} jeweils unabhängig eine C₁₋₂₀-Alkylgruppe sind; X⁻ ein Halogenanion ist; und p und q jeweils unabhängig eine ganze Zahl in einem Bereich von 1 und 10 sind, etwa 0,01 bis etwa 5 Gew.-% eines pH-einstellenden Mittels und etwa 0,1 bis 30 Gew.-% eines Metalloxids zu Wasser, das in einer Menge in einem Bereich von etwa 65 bis 99 Gew.-%, basierend auf dem Gesamtgewicht der Schlämme vorliegt, zum Bilden eines Gemischs, und Aufrühren des Gemischs.

15. Verfahren nach Anspruch 14, wobei das fluorierte oberflächenaktive Mittel eine nichtionische Perfluoralkylsulfonylverbindung der Formel 1 ist:
CF₃(CF₂)ₙSO₂X (1)
wobei n eine ganze Zahl von 1 bis etwa 20 ist; X ausgewählt ist aus der Gruppe, bestehend aus COOR, OR, (OCH₂CH₂)ₘOCH₂CH₃ und (OCH₂CH(OH)CH₂)ₘOCH₂CH(OH)CH₃; R eine C₁₋₂₀-Alkylgruppe ist; und m eine ganze Zahl von 1 bis etwa 100 ist.

16. Verfahren nach Anspruch 15, wobei Rₐ, R_{b}, R_{c}, R_{d}, Rₑ und R_{f} jeweils unabhängig eine C₁-C₄-Alkylgruppe sind; p und q jeweils 1 sind; und X⁻ Cl⁻ ist.

17. Verfahren zum Polieren einer Oberfläche aus polykristallinem Silicium, umfassend das Zuführen einer Schlämmzusammensetzung auf eine Oberfläche aus polykristallinem Silicium, wobei die Schlämmzusammensetzung (a) ein Metalloxid; (b) ein pH-einstellendes Mittel; (c) ein fluoriertes oberflächenaktives Mittel; und (d) eine quartäre oberflächenaktive Ammoniumverbindung der Formel 2 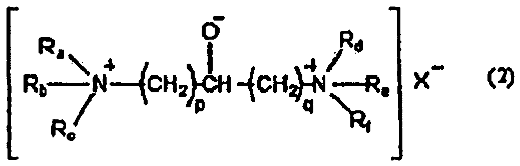 wobei Rₐ, R_{b}, R_{c}, R_{d}, Rₑ und R_{f} jeweils unabhängig eine C₁₋₂₀-Alkylgruppe sind; X⁻ ein Halogenanion ist; und p und q jeweils unabhängig eine ganze Zahl in einem Bereich von 1 und 10 sind,. umfasst; und Durchführen eines CMP-Verfahrens zum Polieren der Oberfläche aus polykristallinem Silicium.

18. Verfahren nach Anspruch 17, wobei das fluorierte oberflächenaktive Mittel eine nichtionische Perfluoralkylsulfonylverbindung der Formel 1 ist:
CF₃(CF₂)ₙSO₂X (1)
wobei n eine ganze Zahl von 1 bis etwa 20 ist; X ausgewählt ist aus der Gruppe, bestehend aus COOR, OR, (OCH₂CH₂)ₘOCH₂CH₃ und (OCH₂CH(OH)CH₂)ₘOCH₂CH(OH)CH₃; R eine C₁₋₂₀-Alkylgruppe ist; und m eine ganze Zahl von 1 bis etwa 100 ist.

19. Verfahren nach Anspruch 17, wobei Rₐ, R_{b}, R_{c}, R_{d}, Rₑ und R_{f} jeweils unabhängig eine C₁₋C₄-Alkylgruppe sind; p und q jeweils 1 sind; und X⁻ Cl⁻ ist.

## Revendications

1. Composition de pâte de polissage mécanique-chimique (CMP) comprenant :
(a) un oxyde métallique ;
(b) un agent d'ajustement du pH ;
(c) un tensioactif fluoré ; et
(d) un tensioactif à base d'ammonium quaternaire, représenté par la formule 2 : 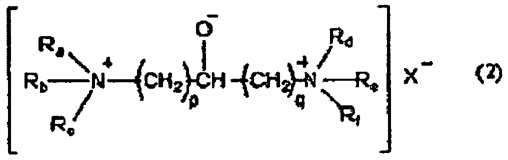
dans laquelle Rₐ, R_{b}, R_{c}, R_{d}, Rₑ et R_{f} représentent chacun un groupe alkyle en C₁₋₂₀ ; X⁻ est un anion halogène ; et p et q représentent chacun indépendamment de l'autre un entier compris dans la plage de 1 à 10.

2. Composition de pâte CMP selon la revendication 1, dans laquelle le tensioactif fluoré comprend un composé perfluoralkylsulfonylé non ionique.

3. Composition de pâte CMP selon la revendication 2, dans laquelle le composé perfluoralkylsulfonylé non ionique comprend un composé représenté par la formule 1 :
CF₃(CF₂)ₙSO₂X (1)
dans laquelle n est un entier de 1 à environ 20 ;
X est choisi dans le groupe consistant en COOR, OR, (OCH₂CH₂)ₘOCH₂CH₃ et (OCH₂CH(OH)CH₂)ₘOCH₂CH(OH)CH₃ ;
R est un groupe alkyle en C₁₋₂₀ ;
et m est un entier de 1 à environ 100.

4. Composition de pâte selon la revendication 1, dans laquelle le tensioactif fluoré est présent en une quantité comprise dans la plage d'environ 0,001 à environ 1 % en poids par rapport au poids total de la composition de pâte.

5. Composition de pâte CMP selon la revendication 1, dans laquelle Rₐ, R_{b}, R_{c}, R_{d}, Rₑ et R_{f} représentent chacun indépendamment des autres un groupe alkyle en C₁-C₄ ; p et q valent chacun 1 ; et X⁻ est Cl⁻.

6. Composition de pâte selon la revendication 1, dans laquelle le tensioactif à base d'ammonium quaternaire est présent en une quantité comprise dans la plage d'environ 0,001 à environ 1 % en poids par rapport au poids total de la composition de pâte.

7. Composition de pâte CMP selon la revendication 1, dans laquelle l'agent d'ajustement du pH comprend une base à base d'ammonium quaternaire.

8. Composition de pâte selon la revendication 7, dans laquelle la base à base d'ammonium quaternaire comprend au moins un composé choisi dans le groupe consistant en l'hydroxyde de tétraméthylammonium, l'hydroxyde de tétraéthylammonium, l'hydroxyde de tétrapropylammonium et l'hydroxyde de tétrabutylammonium.

9. Composition de pâte selon la revendication 1, dans laquelle l'agent d'ajustement du pH est présent en une quantité comprise dans la plage d'environ 0,01 à environ 5 % en poids par rapport au poids total de la composition de pâte.

10. Composition de pâte selon la revendication 1, dans laquelle l'oxyde métallique comprend au moins un composé choisi dans le groupe consistant en SiO₂, Al₂O₃, CeO₂, ZrO₂ et TiO₂.

11. Composition de pâte selon la revendication 1, dans laquelle l'oxyde métallique a une granulométrie primaire comprise dans la plage d'environ 10 à environ 300 nm et une aire spécifique comprise dans la plage d'environ 10 à environ 300 m²/g.

12. Composition de pâte selon la revendication 3, dans laquelle le tensioactif fluoré comprend au moins deux tensioactifs fluorés différents, les au moins deux tensioactifs fluorés différents étant représentés par la formule 1.

13. Composition de pâte selon la revendication 1, dans laquelle le tensioactif à base d'ammonium quaternaire comprend au moins deux tensioactifs à base d'ammonium quaternaire différents, représentés par la formule 2.

14. Procédé de préparation d'une composition de pâte CMP, comprenant l'addition, pour former un mélange, d'environ 0,001 à environ 1 % en poids d'un tensioactif fluoré, d'environ 0,001 à environ 1 % en poids d'un tensioactif à base d'ammonium quaternaire, représenté par la formule 2 : 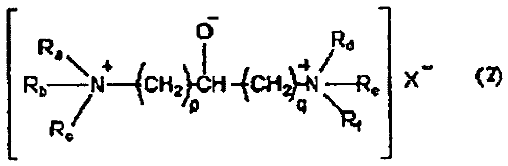 dans laquelle Rₐ, R_{b}, R_{c}, R_{d}, Rₑ et R_{f} représentent chacun un groupe alkyle en C₁₋₂₀ ; X⁻ est un anion halogène ; et p et q représentent chacun indépendamment de l'autre un entier compris dans la plage de 1 à 10,
d'environ 0,01 à environ 5 % en poids d'un agent d'ajustement du pH, et d'environ 0,1 à 30 % en poids d'un oxyde métallique à de l'eau, qui est présente en une quantité comprise dans la plage d'environ 65 à 99 % en poids par rapport au poids total de la pâte, et l'agitation du mélange.

15. Procédé selon la revendication 14, dans lequel le tensioactif fluoré est un composé perfluoralkylsulfonylé non ionique représenté par la formule 1 :
CF₃(CF₂)ₙSO₂X (1)
dans laquelle n est un entier de 1 à environ 20 ;
X est choisi dans le groupe consistant en COOR, OR, (OCH₂CH₂)ₘOCH₂CH₃ et (OCH₂CH(OH)CH₂)ₘOCH₂CH(OH)CH₃ ;
R est un groupe alkyle en C₁₋₂₀ ;
et m est un entier de 1 à environ 100.

16. Procédé selon la revendication 15, dans laquelle Rₐ, R_{b}, R_{c}, R_{d}, Rₑ et R_{f} représentent chacun indépendamment des autres un groupe alkyle en C₁-C₄ p et q valent chacun 1 ; et X⁻ est Cl⁻.

17. Procédé de polissage d'une surface de silicium polycristallin, comprenant l'application d'une composition de pâte sur une surface de silicium polycristallin, la composition de pâte comprenant (a) un oxyde métallique ; (b) un agent d'ajustement du pH ; (c) un tensioactif fluoré ; et (d) un tensioactif à base d'ammonium quaternaire, représenté par la formule 2 : 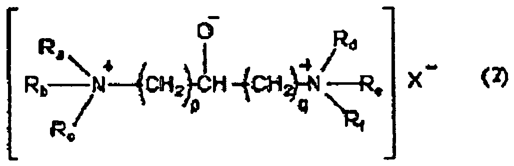 dans laquelle Rₐ, R_{b}, R_{c}, R_{d}, Rₑ et R_{f} représentent chacun un groupe alkyle en C₁₋₂₀ ; X⁻ est un anion halogène ; et p et q représentent chacun indépendamment de l'autre un entier compris dans la plage de 1 à 10,
et la mise en oeuvre d'une opération de polissage CMP pour polir la surface de silicium polycristallin.

18. Procédé selon la revendication 17, dans lequel le tensioactif fluoré est un composé perfluoralkylsulfonylé non ionique représenté par la formule 1 :
CF₃(CF₂)ₙSO₂X (1)
dans laquelle n est un entier de 1 à environ 20 ;
X est choisi dans le groupe consistant en COOR, OR, (OCH₂CH₂)ₘOCH₂CH₃ et (OCH₂CH(OH)CH₂)ₘOCH₂CH(OH)CH₃ ;
R est un groupe alkyle en C₁₋₂₀ ;
et m est un entier de 1 à environ 100.

19. Procédé selon la revendication 17, dans laquelle Rₐ, R_{b}, R_{c}, R_{d}, Rₑ et R_{f} représentent chacun indépendamment des autres un groupe alkyle en C₁-C₄ ; p et q valent chacun 1 ; et X⁻ est Cl⁻.
